# EUROPEAN PATENT APPLICATION

(11) **EP 3 340 427 A1**
(43) Date of publication of application: **27.06.2018**
(21) Application number: 17209893.1
(22) Date of filing: 21.12.2017
(51) Int. Cl.: H02J 7/02, H02J 7/04, H04B 5/00, H02J 7/00, H02J 50/12

(54) **METAL FRAME TRANSMITTING THE ELECTROMAGNETIC WAVES OR HAVING THE FUNCTION OF HEAT RADIATION**

(30) Priority: 22.12.2016 KR 20160177064; 09.11.2017 KR 20170149013
(71) Applicant: Kim, Jae Beom, Seoul 06548 (KR)
(72) Inventor: Kim, Jae Beom, Seoul 06548 (KR)
(74) Representative: Pfenning, Meinig & Partner mbB

(57) **Abstract**

Provided herein is a metal frame transmitting electromagnetic waves or having a function of heat radiation, wherein the metal frame includes metal as its main substance, wherein the metal frame is applied to a device having a function of transmitting electromagnetic waves, and wherein the metal frame includes a slit formed on at least a partial area of the metal frame, wherein the slit forming area is larger than an area occupied by a wireless transmitting/receiving module for transmitting electromagnetic waves, and wherein an entire area occupied by the wireless transmitting/receiving module is located under at least part of the slit forming area.

According to the above-described invention, a slit is formed on at least a partial area of the metal frame, and, by overlaying the entire area of the wireless transmitting/receiving module within the slit area, the characteristic of transmitting electromagnetic waves is provided to the metal frame. Accordingly, the metal frame may be applied and used as an outer case of a device being provided with transmitting/receiving modules for wireless communication or wireless charging, and the metal frame may also be used as an interior material of the device.

## Description

### BACKGROUND OF THE INVENTION

### Field of the Invention

The present invention relates to a metal frame transmitting electromagnetic waves or having a function of heat radiation and, more particularly, to a metal frame transmitting electromagnetic waves or having a function of heat radiation, wherein a slit having a predetermined width is formed on at least a partial area of the metal frame so as to allow electromagnetic waves to be transmitted, thereby allowing the metal frame to be used as an outer case of a device being provided with at least any one selected wireless transmitting/receiving module, which is related to any one of near field communication (NFC), wireless power transmission, mobile payment means, or the metal frame may be embedded and used inside the device. Herein, however, since the generation of an eddy current disturbs the transmission of electromagnetic waves, it very important to establish a condition that prevents the eddy current from be generated. And, in order to do so, the slit forming area should be larger than the size of the module (i.e., area being occupied by the module).

### Discussion of the Related Art

Recently, the wireless charging technology has evolved at a remarkable rate and is being extensively applied in diverse types of appliances including mobile devices.

Such wireless charging may also be referred to as non-contact charging and may be broadly divided into two different types: a method using electromagnetic induction and a method using magnetic resonance.

The electromagnetic induction type charging technology corresponds to a method of charging batteries by generating an induced current between a charging pad and two coils provided inside a mobile phone. And, the charging method using magnetic resonance corresponds to a method of performing charging by sending out power through the same frequency to a transmitting/receiving end that is located several meters (m) away from the charging system. Herein, as the currently most commonly used technology, since the electromagnetic induction type charging method uses frequencies of several hundreds of kilohertz (kHz), most particularly, this technology may be used to perform wireless charging of mobile phones, laptop computers, and other mobile devices, which use frequencies within a range of 100 to 300 kHz. Furthermore, this method may also be used for charging electric mobile vehicles.

Meanwhile, manufacturers of mobile devices, such as mobile phones, have consistently developed their technologies in order to maximize the performance of their mobile devices and, eventually, achieved their goal of realizing a state-of-the-art mobile device technology. However, the manufacturers are gradually reaching their limits in enhancing the performance of the devices. Therefore, it has become difficult to find any distinction in device performances between manufacturers.

Accordingly, the manufacturers are becoming more focused on the design of their mobile devices, and, therefore, the selection of the material for a frame configuring the external features of the mobile device has become one of the most important issues.

More specifically, until recently, in order to manufacture light-weight mobile devices, the manufacturers have mostly fabricated their mobile devices by using plastic material. However, due to the characteristics of the plastic material, the manufacturers have reach their limitations in achieving high-quality texture in the mobile devices using plastic material. Eventually, manufacturers are searching for an alternative material that can realize a completely new texture. However, the manufacturers are facing many difficulties in discovering such material.

Metallic external features may be considered to be one of the most adequate candidates for replacing plastic external features. However, since metal has a tendency to block electromagnetic waves, not to mention that metal is actually being used as an excellent material for blocking electromagnetic waves. Therefore, metal is not an adequate material to be used in diverse wireless transmitting/receiving modules, which perform diverse functions such as wireless charging, near field communication (NFC), Samsung Pay, and so on.

Therefore, a material that can be used for the outer case of mobile devices as a replacement for plastic in order to further enhance the aesthetic external features of mobile devices is being required. Herein, a metal frame may be applied. However, it will be more preferable that the metal frame allows the wireless transmitting/receiving modules to carry out theirs functions despite the metallic characteristics of the frame.

Furthermore, in the aspect of heat radiation, metal is also known to be the material having the most excellent heat radiation characteristics. Therefore, it will be more preferable for the metal frame to enhance the heat radiation characteristics while ensuring the operations of the diverse wireless transmitting/receiving modules, which are described above.

### Documents of Prior Art

### Documents of Patent

(Document of Patent 0001) Published document of Korean Patent Application No.2014-0008130
(Document of Patent 0002) Published document of Korean Patent Application No.2014-0008273
(Document of Patent 0003) Published document of Korean Patent Application No.2014-0104242
(Document of Patent 0004) Published document of Korean Patent Application No.2014-0113147

### Documents besides Patent

(Document besides Patent 0001) "Design of Compact CPW-fed Slot Antenna Using Split-Ring Resonators", Journal of the Korea Institute of Information and Communication Engineering Volume 18, Issue10, p2351∼2358, 31 Oct 2014 (http://central.oak.go.kr/journallist/journaldetail.do;jsessionid=E4FE5E83B5B811E6E3025 D752C9557C7?article_seq=14937&tabname=abst&resource_seq=-1&keywords=null)

### SUMMARY OF THE INVENTION

### Problems to be solved

Accordingly, the present invention is directed to obviate one or more problems due to limitations and disadvantages of the related art, a technical object of the present invention is to enable a metal frame to have at least a function of transmitting electromagnetic waves by forming a slit at a location on the metal frame corresponding to at least a partial area, most particularly, a coil forming area that is provided on a substrate in order to perform wireless charging, near field communication, and mobile payment, where the slit forming area is formed to be larger than the coil forming area.

Another object of the present invention is to provide a frame that can be used as an outer case of a communication device, a wireless charging transmitter, a wireless charging receiver, and so on, each being equipped with a wireless communication module or a wireless transmitting/receiving module, even though the frame is made of a metallic material.

Yet another object of the present invention is to provide a metal frame transmitting electromagnetic waves or having a function of heat radiation that can enhance the aesthetic external features of an applied device and that can further enhance the overall durability of the applied device by adopting a metallic material having a more excellent and luxurious texture than plastic.

Yet another object of the present invention is to provide a metal frame transmitting electromagnetic waves or having a function of heat radiation that can enhance the visual effect of the exterior of the device and enhance the aesthetic external features of the device by forming a slit on each metal frame having a different color and by layering one metal frame over another so that the slits to do not overlap, thereby allowing the frame to be formed to have diverse colors.

A further object of the present invention is to provide a metal frame transmitting electromagnetic waves or having a function of heat radiation that can maximize heat radiation efficiency of the device by alternately using the metal frame as an electromagnetic wave transmission means and a heat radiation means, wherein the metal frame may be used as a replacement for a carbon group heat radiation plate, which corresponds to the related art heat radiation means, or wherein the metal frame may be used in combination with the carbon group heat radiation element.

### Means for solving the problems

To achieve these objects and other advantages and in accordance with the purpose of the invention, as embodied and broadly described herein, according to an exemplary embodiment of the present invention, provided herein is a metal frame transmitting electromagnetic waves or having a function of heat radiation, wherein the metal frame may include metal as its main substance, wherein the metal frame may be applied to a device having a function of transmitting electromagnetic waves, and wherein the metal frame may include a slit formed on at least a partial area of the metal frame, wherein the slit forming area may be larger than an area occupied by a wireless transmitting/receiving module for transmitting electromagnetic waves, and wherein an entire area occupied by the wireless transmitting/receiving module may be located under at least part of the slit forming area.

Preferably, a boundary between the slit or groove and the second layer may be formed in one of straight lines, curved lines, and spiral lines.

Preferably, the slit may be extended to form at least one pattern consisting of one of straight lines, curved lines, and spiral lines.

Preferably, the slit may be formed or processed by using at least one of 3D printing, plating, sawing, laser treatment, punching, and etching.

Preferably, the slit may have a width exceeding 0 millimeter (mm) and equal to or less than several millimeters (mm).

Preferably, the metal frame may include aluminum or copper.

Preferably, the metal frame may be installed at a location corresponding to a main transmitting direction or a main receiving direction of a transmitting unit or receiving unit of wireless power or wireless charging equipped in the device.

Preferably, a plurality of metal frames may be layered in a multi-layer structure on a near field communication (NFC) module, thereby amplifying an electromagnetic field.

Preferably, the plurality of metal frames may be layered so that patterns are identical to one another, or that patterns are alternated.

Preferably, the metal frame may replace a carbon-based heat radiation plate, or the metal frame may be used in combination with a carbon-based heat radiation plate.

Preferably, a plurality of metal frames may be layered one over another, an insulating layer may be included at least partly between each metal frame, and the insulating layer may correspond to any one of air, a film, and a coating layer.

Preferably, a lower metal frame and an upper metal frame may be configured to have different colors so that the color of the lower metal frame is recognized through the slit of the upper metal frame.

Preferably, a film or coating layer of the lower metal frame and the upper metal frame may be configured to have different colors so that the color of the film or coating layer is recognized through the slit of the upper metal frame.

Preferably, when the upper metal frame and the lower metal frame are layered one over another, a pattern of the lower metal frame may be configured to not overlap with any part of a pattern of the upper frame, thereby allowing a slit formed on the lower metal frame to be hidden.

Preferably, the metal frame may be connected to a substrate so as to be applied to a mobile device and used as an antenna.

Preferably, an average width of a slit may be equal to or less than 2 times an average width between two adjacent slits.

### Effect of the invention

As described above, the metal frame transmitting electromagnetic waves or having a function of heat radiation has the following advantages. According to the exemplary embodiment of the present invention, the metal frame transmitting electromagnetic waves or having a function of heat radiation may have an advantageous effect of enabling a metal frame to have at least a function of transmitting electromagnetic waves by forming a slit at a location on the metal frame corresponding to at least a partial area, most particularly, a coil forming area that is provided on a substrate in order to perform wireless charging, near field communication, and mobile payment, where the slit forming area is formed to be larger than the coil forming area.

According to the exemplary embodiment of the present invention, the metal frame transmitting electromagnetic waves or having a function of heat radiation may have an advantageous effect of providing a frame that can be used as an outer case of a communication device, a wireless charging transmitter, a wireless charging receiver, and so on, each being equipped with a wireless communication module or a wireless transmitting/receiving module, even though the frame is made of a metallic material.

According to the exemplary embodiment of the present invention, the metal frame transmitting electromagnetic waves or having a function of heat radiation may have an advantageous effect of enhancing the aesthetic external features of an applied device and that can further enhance the overall durability of the applied device by adopting a metallic material having a more excellent and luxurious texture than plastic.

According to the exemplary embodiment of the present invention, the metal frame transmitting electromagnetic waves or having a function of heat radiation may have an advantageous effect of enhancing the visual effect of the exterior of the device and enhancing the aesthetic external features (or beautiful exterior design) of the device by forming a slit on each metal frame having a different color and by layering one metal frame over another so that the slits to do not overlap, thereby allowing the frame to be formed to have diverse colors.

According to the exemplary embodiment of the present invention, the metal frame transmitting electromagnetic waves or having a function of heat radiation may have an advantageous effect of maximizing heat radiation efficiency of the device by alternately using the metal frame as an electromagnetic wave transmission means and a heat radiation means, wherein the metal frame may be used as a replacement for a carbon group heat radiation plate, which corresponds to the related art heat radiation means, or wherein the metal frame may be used in combination with the carbon group heat radiation element.

### BRIEF DESCRIPTION OF THE DRAWINGS

FIG. 1 illustrates an elevated view and a detailed view for describing a metal frame according to a preferred embodiment of the present invention.
FIG. 2 illustrates a detailed view showing a slit according to a preferred embodiment of the present invention.
FIG. 3 illustrates a detailed view showing diverse examples of a slit according to a preferred embodiment of the present invention.
FIG. 4 illustrates a plane view showing exemplary shapes of a boundary between a slit and a metal frame according to a preferred embodiment of the present invention.
FIG. 5 illustrates a plane view and a cross-sectional view showing a film according to a preferred embodiment of the present invention.
FIG. 6 illustrates cross-sectional views each showing an example of a metal frame according to a preferred embodiment of the present invention.
FIG. 7 illustrates a cross-sectional view showing another example of a metal frame according to a preferred embodiment of the present invention.
FIG. 8 illustrates a graph showing measurements of a heat radiation characteristic respective to slit distances of a metal frame by using a time function according to a preferred embodiment of the present invention.
FIG. 9 illustrates a cross-sectional view showing yet another example of a metal frame according to a preferred embodiment of the present invention.
FIG. 10 illustrates a perspective view and a plane view showing a layered status of a metal frame according to a preferred embodiment of the present invention.
FIG. 11 illustrates a detailed view showing an exemplary comparison of overlapping status between an area of a metal frame where a slit is formed and an area occupied by a module according to a preferred embodiment of the present invention.

### DETAILED DESCRIPTION OF THE INVENTION

Hereinafter, the present invention will be described in more detail based on the appended drawings and the preferred embodiments of the present invention. In describing the present invention, when it is determined that the detailed description on a related disclosed technology may cause ambiguity in the concept (or idea) of the present invention, the detailed description of the same will be omitted for simplicity.

The terms used in the description of the present invention are defined based on their corresponding functions within the present invention. And, since the meaning of such terms may vary in accordance with the intentions or practices of anyone skilled in the art, the definition of the terms used in the description of the present invention should be understood based on the overall context of this specification.

In the present invention, the metal frame may configure the exterior of the device and may also be embedded inside the device. Also, the metal frame may not be configured of a 100% metal, which is capable of performing the function of transmitting electromagnetic waves and heat radiation. And, in the present invention, it is preferable to interpret and understand that the metal frame refers to a frame that includes metal as its main substance.

Additionally, the wireless transmitting/receiving module collectively refers to all modules being capable of performing delivery, transmission, reception, and so on, of electromagnetic waves, such as wireless charging, wireless communication, and so on.

Additionally, including metal as a main substance indicates that metal occupies a largest (or highest) portion of the metal frame as compared to other substances.

Additionally, the metal frame according to the present invention may include a bulk form and also a very thin form, such as a film.

In the present invention, although a mobile phone, which corresponds to a mobile device, is described as a main exemplary embodiment of the device adopting the metal frame, the present invention will not be limited only to this. And, therefore, the present invention may also include laptop computers, wearable devices, wireless chargers, and so on. Additionally, by extending its scope of application, the present invention may also be applied to built-in charging devices, and other non-mobile devices, such as electric appliances. More specifically, since the present invention may be applied to any device being equipped with a function of radiating heat or a function of transmitting electromagnetic waves, there is no particular limitation in the types of devices to which the present invention may be applied.

Additionally, the application of the metal frame according to the present invention will not be limited only to the case of the mobile device. And, therefore, there is no limitation in the applied area of the metal frame.

Additionally, although a lightweight substance, such as aluminum or copper, may be selected as the material (or substance) configuring the metal frame, the present invention will not be limited only to this.

Moreover, although the metal frame may be formed to have the shape of a plate, it will be apparent that the shape of the metal frame according to the present invention will not be limited only to the plate shape.

Herein, several nanometers refer to a range starting from 1 or more to less than 10 nanometers. Several tens of nanometers refer to a range starting from 10 or more to less than 100 nanometers. And, a sub-millimeter refers to a range starting from 0.1 or more to less than 1 millimeter. Furthermore, the terms "several (or several tens)" and "sub-" should be interpreted and understood in accordance with the above-described rule.

Furthermore, a slit refers to a gap (or opening), which is formed on an object, such as a metal frame, by being cut along a direction of the thickness of the metal frame so as to allow light to pass through.

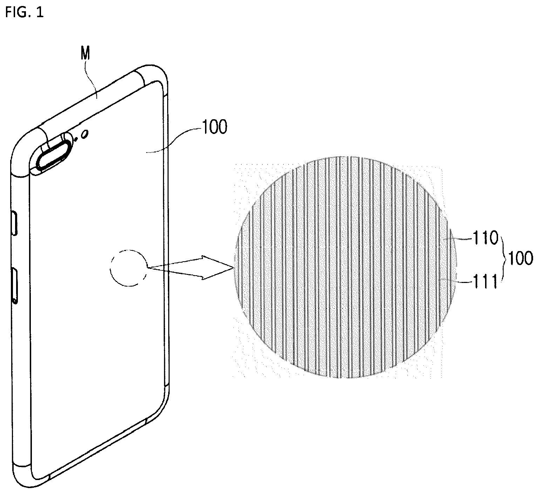

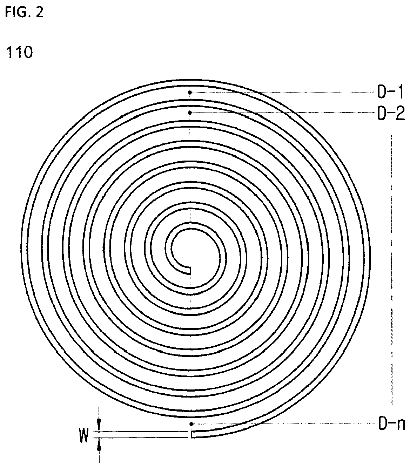

FIG. 1 illustrates a perspective view for describing a metal frame according to a preferred embodiment of the present invention. And, FIG. 2 illustrates a detailed view showing a slit according to a preferred embodiment of the present invention.

As shown in the drawing, as an example, a metal frame 100 may be used as an outer case of a mobile device (M). Herein, for example, a slit 110 having a width (W) equal to or less than several millimeters (mm), so as to provide the metal frame 100, which generally has a function of blocking electromagnetic waves, with a function of transmitting electromagnetic waves. Although it is preferable that the width of the slit is set to be within the range as proposed above, the width of the slit may be larger than the proposed range. However, as the width of the slit becomes narrower than the proposed range, as long as the characteristic of transmitting electromagnetic waves is maintained, a more excellent heat radiating characteristic may be implemented, and a more enhanced durability may be ensured. And, this may also enhance the external aesthetic features (or the exterior design) of the mobile device.

Meanwhile, in case the width of the slit 110 is set to be within a range of several nanometers to several tens of micrometers, it will be difficult to recognize the slit 110 through the human naked eye. Accordingly, a texture that is remarkably different may be achieved, as compared to the case when the slit can be recognized through the human naked eye. Therefore, in order to uses a metal frame having a texture that is similar to a metal frame not having any slit formed therefore, it is preferable to set the width of the slit 110 to a range between several nanometers to several tens of micrometers.

Furthermore, referring to the relationship between D1, D2...... Dn and W, as shown in FIG. 2, it is preferable that an average width (W) value of the slit is equal to or less than 2 times an average distance (D1) between two adjacent slits. This equally applies to the cases when the distance between two slits corresponds to D2, D3... Dn.

However, in this case, it is preferable that the width (W) of the slit is given a value that is within several millimeters (mm) (i.e., less than 10mm).

Meanwhile, the wireless transmitting/receiving module 120 may correspond to a receiving unit and transmitting unit for wireless charging, an NFC module, and a means of mobile payment, such as Samsung Pay, and so on.

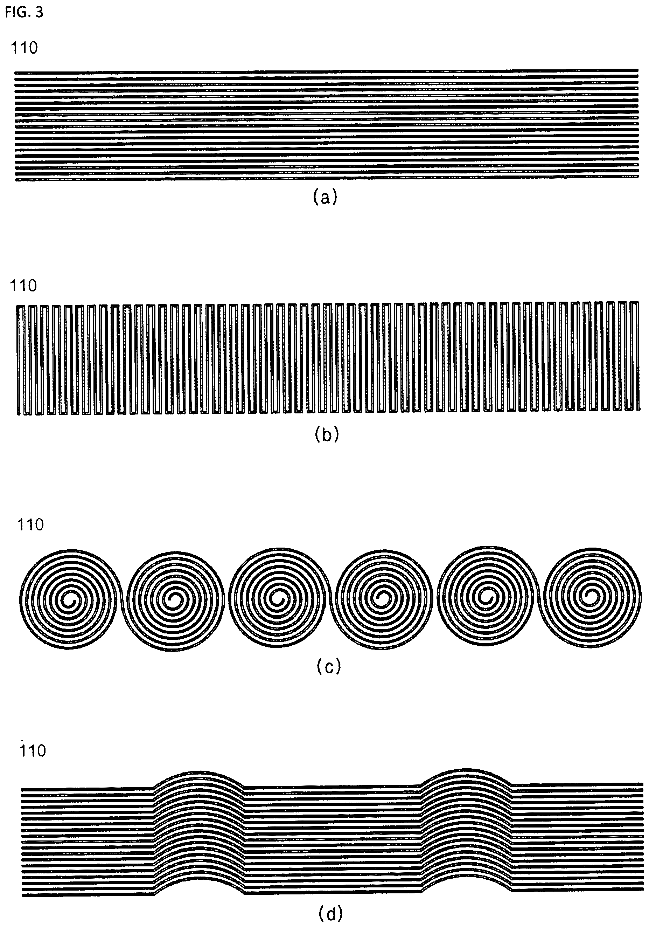

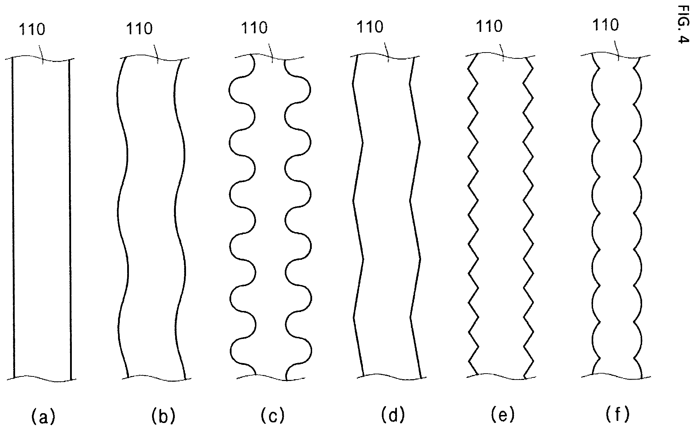

FIG. 3 illustrates a detailed view showing diverse examples of a slit according to a preferred embodiment of the present invention. And, FIG. 4 illustrates a plane view showing exemplary shapes of a boundary between a slit and a metal frame according to a preferred embodiment of the present invention.

As shown in FIG. 3, the slit 110 may show patterns formed in straight lines (FIG. 3a), curved lines (FIG. 3b), and spiral lines (FIG. 3c). Alternatively, the slit 110 may also show patterns formed of a combination of any two of the above-described patterns (FIG. 3d). Also, as shown in FIG. 4, the boundary of the slit 110 may show single-shaped patterns formed in straight lines, curved lines, spiral lines, an uneven structure(a bulgy-and-hollow structure), and so on, or combined patterns configured of a random combination of any two of the above-described patterns.

For example, in case of forming a slit by using the punching process, if the punching process is continuously performed so that the holes formed by each punching process can overlap with one another, the boundary of the slit 110 forms a shape shown in FIG. 4(f).

In addition to the above-described punching method, the method for processing or forming the slit 110 may include processing methods, such as laser treatment, sawing, etching, and so on, and other methods, such as 3d printing, plating, and so on.

Herein, for example, when using the 3d printing and plating methods, a large penetration hole is formed in the metal frame, and, then, a slit form (or shape) may be formed by a 3d printing method by using multiple linear metal supports being connected between the boundary of the penetration hole, and by layering a metal layer on a substrate by using a method, such as electroless plating, so as to form the shape of a slit, and, then, by removing the substrate, the metal frame may be directly fabricated.

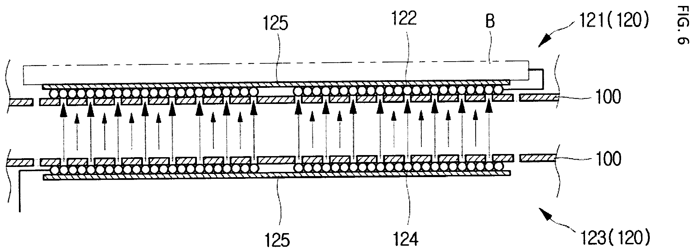

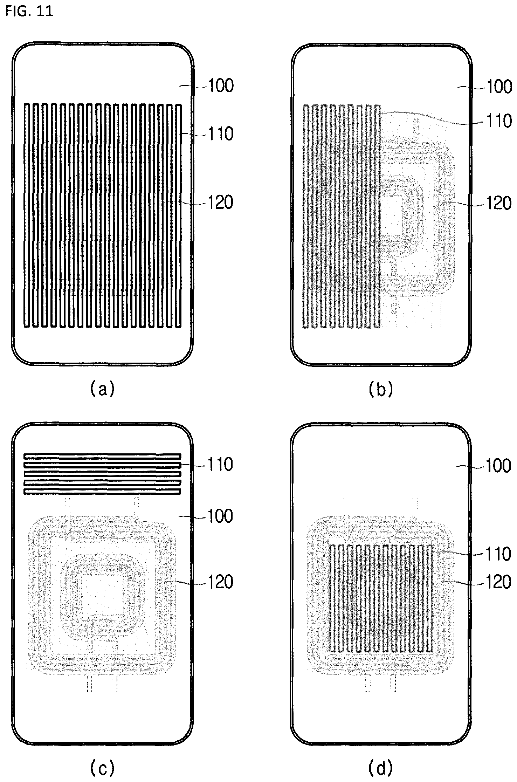

The areas where the above-described slit 110 is formed may be applied throughout the entire metal frame 100. However, when required, the slit 110 may be partially formed on an area corresponding to an area where the wireless transmitting/receiving module 120 is provided, as shown in FIG. 6. However, the area where the slits 110 should occupy a larger range (or area) than the range (or area) occupied by the wireless transmitting/receiving module 120. This may be understood by referring to FIG. 11 shown below. Herein, (a) of FIG. 11 illustrates a preferred embodiment of the present invention, wherein the overall area of the wireless transmitting/receiving module 120 is overlapped by a slit 110 area, which is larger than the overall area of the wireless transmitting/receiving module 120, and (b) to (d) of FIG. 11 illustrate non-preferred embodiments of the present invention. More specifically, (b) corresponds to a case when the slit 110 area is positioned to overlap only a part of the module 120, (c) corresponds to a case when the slit 110 area is positioned to not overlap the module 120 at all, and (d) corresponds to a case when the slit 110 area is smaller than the area of the module 120. Since an eddy current occurs in all of the above-described cases, none of the above-described cases (b) to (d) is preferable for the transmission of electromagnetic waves. In other words, referring to FIG. 11(a), in case of forming a virtual edge on an outermost edge of the area where the slit 110 is formed, this indicates that the wireless transmitting/receiving module 120 should be located within the virtual edge.

It will be apparent that the patterns of the slit 110 shown in FIG. 11(a) are not limited only to the patterns shown in FIG. 11(a).

Most particularly, the area where the slit is formed should be larger than the area occupied by the wireless transmitting/receiving module for transmitting electromagnetic waves, and the overall area occupied by the wireless transmitting/receiving module should be positioned within at least a part of the area where the slit is formed (so as to be covered and/or overlapped by the corresponding area). If the area where the slit is formed overlaps only a part of the area occupied by the module or does not overlap at all the area occupied by the module, or in case the area occupied by the module is smaller than the area where the slit is formed, an eddy current may be generated during the process of transmitting the electromagnetic waves. And, accordingly, since the transmission of the electromagnetic waves is not performed easily, in case of communication, transmission/reception sensitivity may be degraded, or, in case of wireless charging, the duration of the charging time may be extended. For example, in case of a disclosed slot antenna, an eddy current may be generated within a slot of a metal plate, wherein the slot is formed on the metal plate due to the electromagnetic waves that are emitted from an electromagnetic wave emitting module. And, a magnetic flux within the slot may be increased by using the generated eddy current. Thus, due to the magnetic flux of the metal plate itself, the metal plate having a slot formed thereon may be capable of performing the function of an antenna having diverse capabilities (http://central.oak.go.kr/journallist/journaldetail.do;jsessionid=E4FE5E83B5B811E6E3025 D752C9557C7?article_seq=14937&tabname=abst&resource_seq=-1&keywords=null). However, instead of actively performing a particular function (e.g., antenna function) associated with the transmission and/or reception of electromagnetic waves, such as the slot antenna, since the metal frame having the slit formed thereon does not perform any function associated with the transmission and/or reception of electromagnetic waves, it may be said that the two technologies are not correlated to one another. Therefore, the slot antenna should not be identified as the present invention, and the slot antenna should not be considered to be within the same or similar technical scope of the present invention. In other words, the slot antenna should be considered as a completely different technology. Herein, the term "overlapping" indicates that the slit area of the metal frame is positioned to be above the area occupied by the module at a predetermined distance.

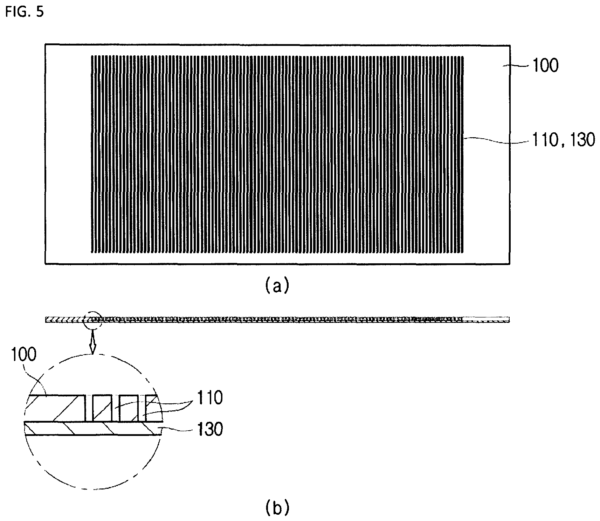

Meanwhile, in addition to the enhanced durability and refined quality of texture of the metal frame 100, as shown in FIG. 5, by additionally considering the color elements, a device adopting the color elements may have a more outstanding exterior appearance (or aesthetic features). This will hereinafter be described in more detail with reference to the accompanying drawings.

FIG. 5 illustrates a plane view and a cross-sectional view showing a film according to a preferred embodiment of the present invention. Herein, FIG. 5a corresponds to the plane view of the metal frame having a film attached thereto, and FIG. 5b corresponds to a cross-sectional view of FIG. 5a. Herein, the film performs the functions of an insulating layer. Conversely, when metal frames each having a different color are layered one over another without attaching any film, wherein at least a portion of the slit do not overlap, the color of the lower metal frame may be exposed through slit 110, which is formed on the upper metal frame. In this case, the upper and lower metal frames should not directly contact one another while facing into each other. Nevertheless, since a partial short may be tolerated (or authorized), interconnection may be realized between the upper and lower metal frames.

More specifically, an air layer, which can at least partly function as an insulating layer, should exist between the upper and lower metal frames. Also, instead of a film, a polymer coating layer having a color may be deposited. The film, the coating layer, and so on, performs the function of preventing direct contact between the upper and lower metal frames.

More specifically, it is preferable that the film, the coating layer, and the air layer is configured to exist in at least a partial area between the upper metal frame and the lower metal frame.

As shown in FIG. 5, a film 130 configured to have a predetermined color is further attached to a lower surface of the metal frame 100. Herein, the color of the film 130 allows the film 130 to be recognized from the outside through the slit 110 of the metal frame. This allows various changes to be made in the external aesthetic features of the device. At this point, since the width of the slit 110 is very small, although the slit itself may not be easily detected through the human naked eye, the color of the film may be recognized through the slit 110 (FIG. 5a).

Also, by blocking the slit 110, the film 130 may also perform a function of blocking out any contaminants (e.g., water or fine dust particles, and so on) from flowing in through the slit 110.

Meanwhile, when layering the upper metal frame and the lower metal frame one over another, the pattern of the low metal frame is configured so that not even a part of the pattern overlaps with a pattern of the upper metal frame. Thus, the slit 110, which is formed in the lower metal case, may be completely hidden (or concealed). Herein, many variations in the external aesthetic features of the device may be made in accordance with the hiding (or concealing) of the slit. In this case, also, since the slit actually exists, there is no change in the characteristic of transmitting electromagnetic waves of the metal frame.

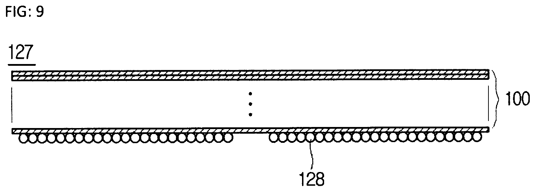

Meanwhile, the metal frame 100 may be used as a case configuring the exterior of a device applying the metal frame 100, and, as shown in FIG. 6 to FIG. 9, the metal frame 100 may also perform a function of radiating heat from the device, and the metal frame 100 may also be used as an antenna that can amplify the electromagnetic waves. This will hereinafter be described in more detail with reference to the accompanying drawings.

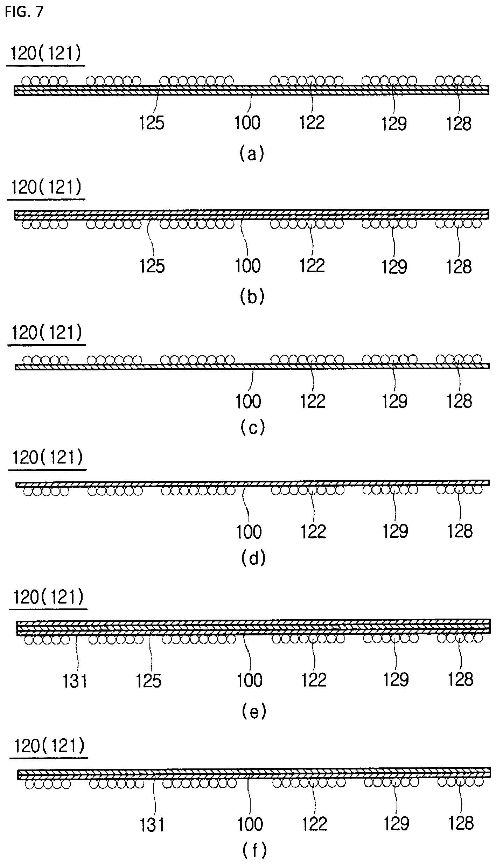

FIG. 6 illustrates cross-sectional views each showing an example of a metal frame according to a preferred embodiment of the present invention. And, FIG. 7 illustrates a cross-sectional view showing another example of a metal frame according to a preferred embodiment of the present invention.

As shown in FIG. 6, the metal frame 100 may be used as an outer case of a transmitting unit 123 in a wireless charger and an outer case of a receiving unit 121 of charging target device. And, accordingly, transmission and reception of power may be easily carried out through the metal frame 100. Thus, a battery (B) of the receiving unit (210) may be stably recharged.

In order to examine the heat radiation characteristic of the metal frame 100, the metal frame 100 being processed to have a slit 110 formed thereon is applied as the outer case of the mobile device. Thereafter, when wireless charging is carried out, the measured temperature is examined. The charging is carried out for approximately 1 hour.

As a result, at the point when 40 minutes is passed, the outer case of the device according to the present invention marks a temperature range of approximately 36 to 39°C, which indicates that there is no problem in the durability of wireless charging. Generally, in case the temperature being measured from the outer case of the corresponding device during wireless charging is equal to 45°C or below, it is understood that there is no significant problem. Accordingly, the metal frame 100 according to the present invention has no default in being applied to the outer case of a wireless charging device or a mobile device, and so on.

As described above, the metal frame 100 may also be embedded inside the device, thereby being capable of releasing the heat generated from diverse wireless transmitting/receiving modules 120.

Meanwhile, due to its excellent thermal conductivity, metal may be the most preferable heat radiation material. However, when metal is applied to the wireless transmitting/receiving module 120, a problem of blocking the electromagnetic waves may occur. Ultimately, metal cannot be used as a heat radiation material of the device having the function of transmitting or receiving electromagnetic waves. And so, heat radiation elements of the carbon group and, most particularly, graphite has been generally used as the heat radiation means of the wireless transmitting/receiving module.

However, since slit 110 is provided on the metal frame 100, even if the frame is configured of a metallic substance, the electromagnetic waves may be transmitted by passing through the slit 110. Accordingly, the metal frame 100 may also be applied as the means of heat radiation of the wireless transmitting/receiving module 120.

In this case, as shown in FIG. 7a and b, the metal frame 100 may be layered along with the graphite 125 heat radiation element. Alternatively, as shown in FIG. 7c and d, the metal frame 100 may also be used by replacing the graphite 125 heat radiation element. When the graphite 125 heat radiation element is also included in the layering, there is no particular limitation in the layering order, the shape and form of the graphite 125 heat radiation element, and the layering method.

Moreover, as shown in FIG. 7e and f, a magnetic sheet 131 may be further deposited on the wireless transmitting/receiving module. And, therefore, the magnetic sheet 131 may be used by being layered with the metal frame 100, or the magnetic sheet 131 may be used by being layered with the metal frame 100 and the graphite 125 heat radiation element. In this case, the layering order of the magnetic sheet 131, the metal frame 100, and the graphite 125 heat radiation element may include all number of possible cases. Herein, the magnetic sheet 131 performs the same function as the conventional wireless transmitting/receiving module.

Meanwhile, in case the graphite 125 is layered with the metal frame 100 according to the present invention, the following effects may be expected. More specifically, graphite 125 corresponds to a plate having a crystal structure. However, since its interlayer binding force is weak, although graphite has an excellent thermal transmission characteristic along a two-dimensional horizontal direction, its vertical thermal (or heat) transmission characteristic is very weak. However, since the metal frame 100 is highly conductive, its characteristic of transmitting heat along the vertical direction is excellent. Therefore, the metal frame 100 may compliment the disadvantages in thermal transmission characteristic of graphite 125.

Herein, the graphite 125 heat radiation element corresponds to an example of the carbon group heat radiation element. And, therefore, it will be apparent that the same applications may be made to other carbon group heat radiation elements.

At this point, although graphite 125 may be coated on the metal frame 100, the metal frame 100 may be coated on the graphite 125.

Furthermore, an adhesion layer may be formed in-between all layers shown in FIG. 7. And, herein, the type of adhesive is not particularly limited, as long as the adhesive corresponds to an adhesive that is generally used in electronic devices.

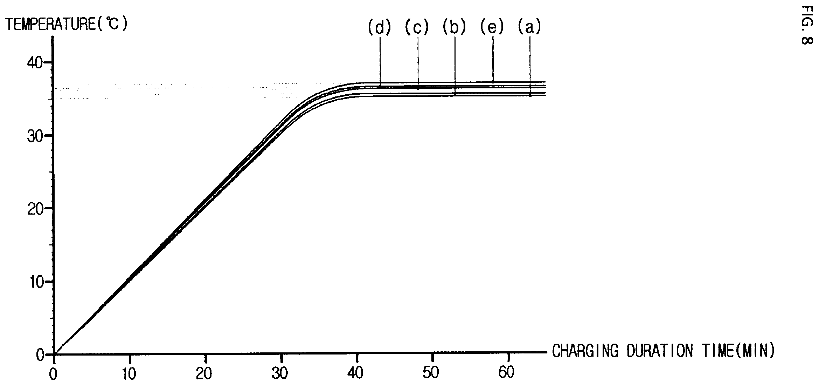

In FIG. 8, the metal frame 100 having a slit width of 0.01mm (a), 1mm (b), 10mm (c), and 15mm (d) is shown in the form of a temperature function with respect to time, and each temperature function is indicated in comparison with graphite (e), which corresponds to the standard material.

As shown in the drawing, in case the width of the slit is equal to 15mm, its saturation temperature marks a high. Accordingly, it can be understood that its heat radiation characteristic is lower than the cases when the width of the slit is equal to 0.01mm, 1mm, and 10mm. Meanwhile, in case the width of the slit is equal to 0.01mm and 1mm, the heat radiation characteristics are similar to the heat radiation characteristic of graphite. And, although the case when the width of the slit is equal to 10mm marks a rather high temperature level, it can be understood that its heat radiation characteristic marks a valid level. Therefore, it can be understood that the metal frame 100 according to the present invention has no default in being used as the heat radiation material of the corresponding device.

In conclusion, when using the metal frame 100 having a slit 110 formed thereon according to the present invention, over-heating of the wireless transmitting/receiving module 120 may be prevented. Accordingly, this is advantageous in that safety-related accidents, which are caused by such overheating, can be prevented, and that damage caused to the device can also be prevented.

At this point, the wireless transmitting/receiving module 120 may correspond to a transmitting unit 123 for power transmission, a receiving unit 121, an NFC module 127, an MST module 129 for performing mobile payment, such as Samsung Pay, and so on. As shown in FIG. 7, the metal frame 100 is provided to a transmitting unit coil 124, a receiving unit coil 122, and an NFC coil 128, which correspond to the source of heat radiation, independently or in combination with graphite 125.

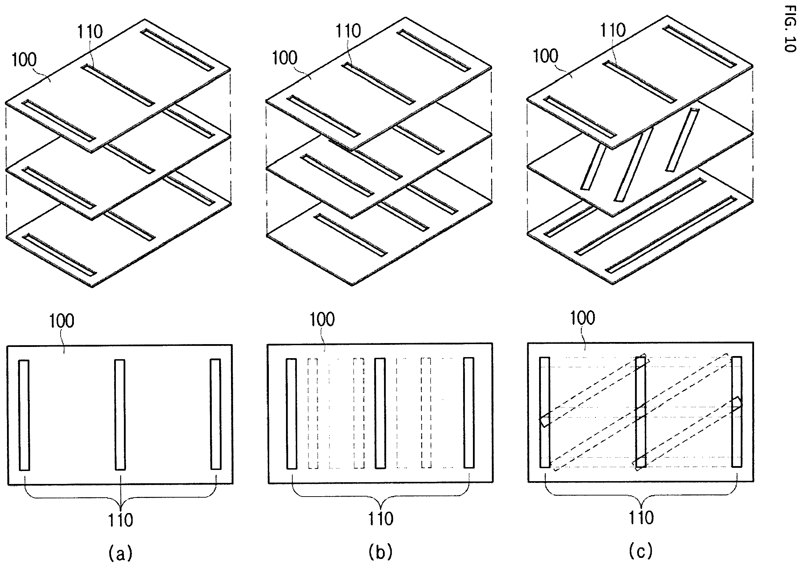

Such metal frame 100 may be layered so that the patterns of each slit 110 identically coincide with one another, as shown in FIG. 10a, or the metal frame 100 may be layered so that the patterns of each slit 110 are alternated, as shown in FIG. 10b and c. Referring to FIG. 10b, the slits of the lower metal frames may all be hidden by the highest metal frame, and, referring to FIG. 10c, at least part of the slits of each lower metal frame may be exposed through the slit of its upper metal layer.

As described above, the present invention is very significant in that the characteristic of transmitting electromagnetic waves has been provided by forming a slit in metal. Therefore, the industrial applicability of the present invention is being recognized in that a metal frame can be directly applied and used in mobile devices.

It will be apparent to those skilled in the art that various modifications and variations can be made in this specification without departing from the spirit or scope of this specification. Thus, it is intended that this specification covers the modifications and variations of this invention provided they come within the scope of the appended claims and their equivalents. It is also apparent that such variations of this specification are not to be understood individually or separately from the technical scope or spirit of this specification.

**Explanation of Reference number in Figures**

| | |
|---|---|
| 100 : metal frame | 110 : slit |
| 120 : Wireless transmitting/receiving module | 121 : Receiving unit |
| 122 : Receiving unit coil | 123 : Transmitting unit |
| 124 : Transmitting unit coil | 125 : Graphite |
| 127 : NFC module | 128 : NFC coil |
| 129 : MST module | 130 : Film |
| 131 : Magnetic sheet | |

## Claims

1. A metal frame transmitting electromagnetic waves or having a function of heat radiation, wherein the metal frame includes metal as its main substance,
wherein the metal frame is applied to a device having a function of transmitting electromagnetic waves, and
wherein the metal frame includes a slit formed on at least a partial area of the metal frame, wherein the slit forming area is larger than an area occupied by a wireless transmitting/receiving module for transmitting electromagnetic waves, and wherein an entire area occupied by the wireless transmitting/receiving module is located under at least part of the slit forming area.

2. The metal frame of claim 1, wherein the slit is formed or processed by using at least one of 3D printing, plating, sawing, laser treatment, punching, and etching.

3. The metal frame of claim 1, wherein the metal frame is installed at a location corresponding to a main transmitting direction or a main receiving direction of a transmitting unit or receiving unit of wireless power or wireless charging equipped in the device.

4. The metal frame of claim 1, wherein the metal frame replaces a carbon-based heat radiation plate, or wherein the metal frame is used in combination with a carbon-based heat radiation plate.

5. The metal frame of claim 1, wherein a plurality of metal frames is layered one over another,
wherein an insulating layer is included at least partly between each metal frame, and
wherein the insulating layer corresponds to any one of air, a film, and a coating layer.

6. The metal frame of claim 1, wherein an average width of a slit is equal to or less than 2 times an average width between two adjacent slits.
